(19) **Europäisches Patentamt**

**European Patent Office**

**Office européen des brevets**

(11) **EP 1 411 638 B1**

(12) **FASCICULE DE BREVET EUROPEEN**

(45) Date de publication et mention
de la délivrance du brevet:
**08.02.2006 Bulletin 2006/06**

(51) Int Cl.:
***H03L 7/183*** (2006.01)

(21) Numéro de dépôt: **03292236.1**

(22) Date de dépôt: **11.09.2003**

(54) **Procédé et dispositif de génération d'un signal ayant une fréquence égale au produit d'une fréquence de référence par un nombre réel**

Verfahren und Vorrichtung zur Erzeugung eines Signals mit einer dem Produkt einer Referenzfrequenz mit einer reellen Zahl entsprechenden Frequenz

Method and apparatus for generating a signal having a frequency equal to the product of a reference frequency by a real number

(84) Etats contractants désignés:
**DE FR GB IT**

(30) Priorité: **17.10.2002 FR 0212937**

(43) Date de publication de la demande:
**21.04.2004 Bulletin 2004/17**

(73) Titulaire: **STMicroelectronics S.A.**
**92120 Montrouge (FR)**

(72) Inventeurs:
• **Joet, Loic**
**38640 Claix (FR)**
• **Dedieu, Sébastian**
**38920 Crolles (FR)**
• **Andre, Eric**
**38570 Hurtières (FR)**

• **Saias, Daniel**
**75005 Paris (FR)**

(74) Mandataire: **Casalonga, Axel**
**BUREAU D.A. CASALONGA - JOSSE**
**Paul-Heyse-Strasse 33**
**80336 München (DE)**

(56) Documents cités:
**US-A- 5 821 816      US-A1- 2002 140 512**

• **ABDELOUAHAB DJEMOUAI ET AL.: "New Frequency-Locked Loop Based on CMOS Frequency-to-Voltage Converter: Design and Implementation" IEEE TRANSACTIONS ON CIRCUITS AND SYSTEMS-II: ANALOG AND DIGITAL SIGNAL PROCESSING, vol. 48, no. 5, mai 2001 (2001-05), pages 441-449, XP002247796**

**Description**

L'invention concerne la synthèse de fréquence et s'applique avantageusement mais non limitativement au domaine de la communication sans fil, en particulier aux téléphones mobiles qui incorporent dans leur chaîne d'émission/réception des moyens de synthèse de fréquence.

Une boucle à verrouillage de phase (PLL :"phase locked loop", en langue anglaise) est généralement très utilisée pour la synthèse de fréquence. En effet, un tel système rebouclé permet de multiplier une fréquence de référence par un nombre entier et ainsi d'adresser toute une plage de fréquences avec un certain pas de fréquence. Plus précisément, une boucle à verrouillage de phase est un système d'asservissement générant une fréquence N fois plus grande que la fréquence de référence qu'il reçoit en entrée, N étant un nombre entier. Ainsi, la fréquence de sortie, qui est donnée par un oscillateur commandé en tension, est divisée par N, puis comparée à une référence qui peut être fournie par un quartz. Une pompe de charge, formée de deux sources de courant, réagit alors en injectant ou en retirant du courant dans le filtre intégrateur qui pilote l'oscillateur de sortie.

Dans le cas où la fréquence de sortie de l'oscillateur est une fonction croissante de sa tension d'entrée, la réaction de la boucle est basée sur le principe suivant. Le comparateur de front détecte le premier des deux fronts. Si ce front détecté appartient au signal de référence, la pompe de charge reçoit l'ordre d'envoyer du courant dans le filtre intégrateur. En effet, dans ce cas, le signal de sortie, divisé par N, est en retard sur le signal de référence et il faut donc augmenter la tension aux bornes de l'oscillateur.

Inversement, si le premier front détecté est celui du signal de sortie divisé par N, alors la pompe de charge absorbe du courant pour que la tension aux bornes de l'oscillateur baisse. A l'apparition du second front, la pompe de charge cesse son activité en attendant le front suivant. Ainsi, plus les fronts seront proches et plus la charge injectée sera petite, jusqu'à ce que la fréquence du signal de sortie de l'oscillateur converge vers N fois la fréquence de référence.

Les boucles à verrouillage de phase permettent de synthétiser des fréquences d'une grande précision et d'une grande stabilité. Leur limitation vient du fait que seule la synthèse de multiples entiers est possible, ce qui limite le nombre de fréquences adressables à partir d'une seule fréquence de référence.

Pour pallier au problème de la division non entière, il est possible d'utiliser une boucle à verrouillage de phase dite "fractionnaire", effectuant une succession de divisions par N et N+1. Ainsi, pour réaliser une division par N+0,5, on divise une fois par N, une fois par N+1 et ainsi de suite. Le filtre intégrateur de la boucle moyenne alors la valeur de la tension pilotant l'oscillateur de sortie de la boucle.

Ce type d'architecture, qui résout le problème de la division à partie décimale pose en contrepartie de gros problèmes de bruit. En effet, contrairement aux boucles à verrouillage de phase classiques évoquées ci-avant, dans lesquelles les injections de courant diminuent jusqu'à devenir négligeables en régime établi, les boucles à verrouillage de phase fractionnaires conservent de grandes injections de courant tout au long de leur fonctionnement, puisque la fréquence se trouve entre N et N + 1 fois la fréquence de référence, et que l'on ne peut la comparer qu'à des divisions entières.

Ces injections de courant répétées entraînent du bruit qu'il est nécessaire de répartir. Et, c'est la taille de la séquence binaire commandant le diviseur par N ou N+1 qui va imposer cette répartition.

Lorsque la séquence est minimum, la tension de l'oscillateur se voit modulée à la fréquence de communication des diviseurs par N et N+1. Le spectre de sortie de la boucle comporte alors deux raies parasites. Et, ces raies peuvent poser de gros problèmes si elles ne respectent pas les spécifications en bruit autour du fondamental.

Par ailleurs, lorsque la séquence s'agrandit, les raies parasites dues à la période de la séquence ont tendance à s'étaler. Cependant, le filtre intégrateur de la boucle a alors le temps de réagir, ce qui entraîne une variation du fondamental au cours du temps. Ainsi, pour des séquences très longues, les raies parasites sont assimilables à du bruit réparti autour de la fréquence générée, en raison d'une modulation non désirée de la fréquence de sortie.

En conclusion, la stabilité de la fréquence de sortie et le plancher de bruit limitent grandement l'utilisation des boucles à verrouillage de phase fractionnaires.

L'invention vise à apporter une solution à ces problèmes.

Un dispositif et un procédé de génération d'un signal désiré ayant une fréquence désirée égale au produit d'une fréquence de référence par un nombre rationnel permettant de pallier aux problèmes des boucles à verrouillage de phase fractionnaire indiqués ci-dessus sont décrits dans le brevet US 5 821 816. Le dispositif antérieur comprend une boucle à verrouillage de phase à division entière comportant un soustracteur comparant la sortie du comparateur de phase de la boucle ave la sortie d'un prédicteur de phase qui utilise la phase du signal de référence, le diviseur entier de la bande et les composantes entière et fractionnaires du nombre rationnel.

Un but de l'invention est de proposer une synthèse de fréquence conservant tous les avantages des boucles à verrouillage classiques tout en supprimant le bruit inhérent aux boucles à verrouillage de phase fractionnaires.

L'invention propose donc un procédé de génération d'un signal désiré ayant une fréquence désirée égale au produit d'une fréquence de référence par un nombre réel.

Selon une caractéristique générale de l'invention, le procédé comporte cycliquement une succession d'une phase de mesure et d'une phase de correction.

La phase de mesure comporte une première division entière de la fréquence du signal de sortie d'un oscillateur par un premier diviseur entier dans un premier moyen de division de fréquence de façon à obtenir un premier signal intermédiaire. Puis, on détermine un premier signal de mesure représentatif de l'écart temporel entre ce premier signal intermédiaire et un signal de référence selon ladite fréquence de référence.

On compare alors un premier signal de comparaison tiré du premier signal de mesure avec un deuxième signal de comparaison dépendant de la période de référence, de la partie entière et de la partie décimale dudit nombre réel, ainsi que du premier diviseur entier, de façon à obtenir un signal d'erreur représentatif de l'écart temporel entre la période du signal de sortie actuel de l'oscillateur et ladite période désirée.

La phase de correction comporte quant à elle une désactivation du premier moyen de division de fréquence et une correction de la commande de l'oscillateur à partir du signal d'erreur, le signal de sortie de l'oscillateur formant le signal désiré.

En d'autres termes, d'une façon générale, la phase de mesure s'effectue au minimum en utilisant une boucle de mesure d'écart temporel à division entière, cette boucle étant ouverte en amont de l'oscillateur commandé en tension. Ainsi, au cours d'une période de mesure, qui est par exemple une période du signal de référence, on compare le premier signal de comparaison, qui est par exemple le produit du premier signal de mesure par un facteur de pondération, avec un deuxième signal de comparaison, qui, lorsqu'on utilise qu'une seule boucle, s'apparente à un signal de consigne qui représente l'écart temporel entre le signal de référence et un signal dont la période est égale à N1 fois la période désirée du signal de sortie désiré, N1 étant le premier diviseur entier.

L'invention permet ainsi de connaître exactement l'écart entre la fréquence de sortie et la fréquence désirée et la boucle réagit à l'écart réel conduisant à une stabilité de la boucle ainsi qu'à une absence des raies parasites inhérentes aux boucles à verrouillage de phase fractionnaires classiques.

Lorsque la phase de mesure s'effectue pendant une période du signal de référence, la phase de correction peut s'effectuer alors pendant la période suivante du signal de référence, et ainsi de suite. Ceci étant, plus généralement, la phase de mesure peut s'effectuer pendant un nombre entier de périodes du signal de référence tandis que la phase de correction peut s'effectuer pendant un autre nombre entier, identique ou différent du premier nombre entier, de périodes suivantes du signal de référence.

Selon un mode de mise en oeuvre préféré de l'invention, l'élaboration du deuxième signal de comparaison peut s'effectuer au sein d'une deuxième boucle de mesure d'écart temporel à division entière.

Plus précisément, selon ce mode de mise en oeuvre, l'élaboration du deuxième signal de comparaison comporte

- une deuxième division entière de la fréquence du signal de sortie de l'oscillateur par un deuxième diviseur entier dans un deuxième moyen de division de fréquence de façon à obtenir un deuxième signal intermédiaire,
- une détermination d'un deuxième signal de mesure représentatif de l'écart temporel entre ce deuxième signal intermédiaire et le signal de référence, et
- une pondération du deuxième signal intermédiaire par un deuxième facteur de pondération obtenue à partir du premier diviseur entier, de la partie entière et de la partie décimale dudit nombre réel.

Par ailleurs, l'élaboration du premier signal de comparaison comporte une pondération du premier signal de mesure par un premier facteur de pondération obtenue à partir du deuxième diviseur entier, de la partie entière et de la partie décimale du nombre réel.

La phase de correction comporte alors également une désactivation du deuxième moyen de division de fréquence.

Ainsi, si par exemple le premier diviseur entier est égal à N1 et que le deuxième diviseur entier est égal à N2, le premier facteur de pondération pourra être égal à -(N2-N-f) tandis que le deuxième facteur de pondération sera égal à N1-N-f, N et f désignant respectivement la partie entière et la partie décimale du nombre réel dont le produit par la fréquence de référence fournit la fréquence désirée;

Ceci étant, une façon particulièrement simple de mettre en oeuvre l'invention consiste par exemple à prendre un premier diviseur entier égal à N+1 et un deuxième diviseur entier égal à N-1. Le premier facteur de pondération est alors égal à 1+f tandis que le deuxième facteur de pondération est alors égal à 1-f.

L'invention a également pour objet un dispositif de génération d'un signal désiré ayant une fréquence désirée égale au produit d'une fréquence de référence par un nombre réel.

Selon une caractéristique générale de l'invention, le dispositif comprend

- un oscillateur commandé,
- un premier moyen de division apte à effectuer une première division entière de la fréquence du signal de sortie de l'oscillateur commandé par un premier diviseur entier de façon à obtenir un premier signal intermédiaire,
- des premiers moyens de détermination aptes à déterminer un premier signal de mesure représentatif de l'écart temporel entre ce premier signal intermédiaire et un signal de référence ayant ladite fréquence de référence,

- des premiers moyens d'élaboration aptes à élaborer un premier signal de comparaison tiré du premier signal de mesure,
- des deuxièmes moyens d'élaboration aptes à élaborer un deuxième signal de comparaison dépendant de la période de référence, de la partie entière et de la partie décimale dudit nombre réel, et dudit premier diviseur entier,
- des moyens de comparaison aptes à effectuer une comparaison entre les deux signaux de comparaison de façon à obtenir un signal d'erreur représentatif de l'écart temporel entre la période du signal de sortie actuel de l'oscillateur et ladite période désirée,
- un interrupteur connecté entre la sortie des moyens de comparaison et l'entrée de commande de l'oscillateur, et
- des moyens de commande aptes à ouvrir et à fermer successivement et cycliquement l'interrupteur et à désactiver le premier moyen de division lorsque l'interrupteur est fermé, de façon à permettre successivement la détermination du signal d'erreur et la délivrance de ce signal d'erreur sur l'entrée de commande de l'oscillateur, le signal de sortie de l'oscillateur formant ledit signal désiré.

Selon un mode de réalisation de l'invention, les moyens de commande ferment et ouvrent l'interrupteur respectivement pendant des périodes successives du signal de référence.

Selon un mode avantageux de réalisation de l'invention, les deuxièmes moyens d'élaboration comportent

- un deuxième moyen de division apte à effectuer une deuxième division entière de la fréquence du signal de sortie de l'oscillateur par un deuxième diviseur entier,
- des deuxièmes moyens de détermination aptes à déterminer un deuxième signal de mesure représentatif de l'écart temporel entre ce deuxième signal intermédiaire et le signal de référence, et
- des deuxièmes moyens de pondération aptes à effectuer une pondération du deuxième signal intermédiaire par un deuxième facteur de pondération obtenu à partir du premier diviseur entier, de la partie entière et de la partie décimale dudit nombre réel.

Par ailleurs, selon ce mode réalisation, les premiers moyens d'élaboration comportent des premiers moyens de pondération aptes à effectuer une pondération du premier signal de mesure par un facteur de pondération obtenu à partir du deuxième diviseur entier, de la partie entière et de la partie décimale du nombre réel.

Et, les moyens de commande sont également aptes à désactiver le deuxième moyen de division lorsque l'interrupteur est fermé.

Le dispositif selon l'invention est avantageusement réalisé sous la forme d'un circuit intégré.

L'invention vise également un terminal d'un système de communication sans fil comportant un dispositif de génération tel que défini ci-avant.

Ce terminal peut être par exemple un téléphone mobile cellulaire.

D'autres avantages et caractéristiques de l'invention apparaîtront à l'examen de la description détaillée d'un mode de réalisation et de mise en oeuvre, nullement limitatif, et des dessins annexés sur lesquels :

- la figure 1 illustre schématiquement un téléphone mobile cellulaire selon l'invention, incorporant un dispositif selon l'invention, et
- la figure 2 illustre plus en détail, mais toujours schématiquement, un mode de réalisation d'un dispositif selon l'invention.

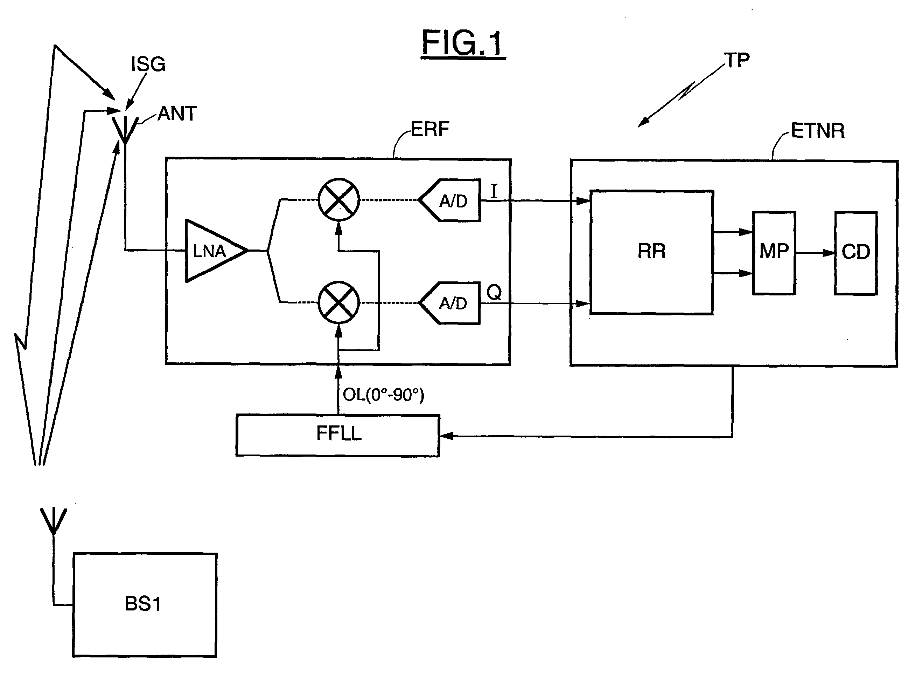

Sur la figure 1, la référence TP désigne un terminal distant, tel qu'un téléphone mobile cellulaire, qui est en communication avec une station de base BS1, par exemple selon un schéma de communication du type CDMA-FDD.

Le téléphone mobile cellulaire comprend, de façon classique, un étage analogique radiofréquence ERF connecté à une antenne ANT pour recevoir un signal d'entrée ISG.

Classiquement, l'étage ERF comprend un amplificateur faible bruit LNA et deux voies de traitement comportant des mélangeurs, des filtres et amplificateurs classiques (non représentés sur la figure 1 à des fins de simplification). Les deux mélangeurs reçoivent respectivement de la part d'un dispositif FFLL selon l'invention deux signaux OL présentant mutuellement une différence de phase de 90°. Après transposition de fréquence dans les mélangeurs, les deux voies de traitement définissent respectivement deux flux I (flux direct) et Q (flux en quadrature) selon une dénomination bien connue de l'homme du métier.

Après conversion numérique, dans des convertisseurs analogiques/numériques, les deux flux 1 et Q sont délivrés à un étage de traitement de réception ETNR.

Cet étage de traitement ETNR comprend un récepteur RR, communément désigné par l'homme du métier "récepteur Rake", suivi par des moyens classiques de démodulation MP qui effectuent la démodulation de la constellation délivrée par le récepteur Rake RR. Les moyens MP sont suivis d'un décodeur canal classique CD.

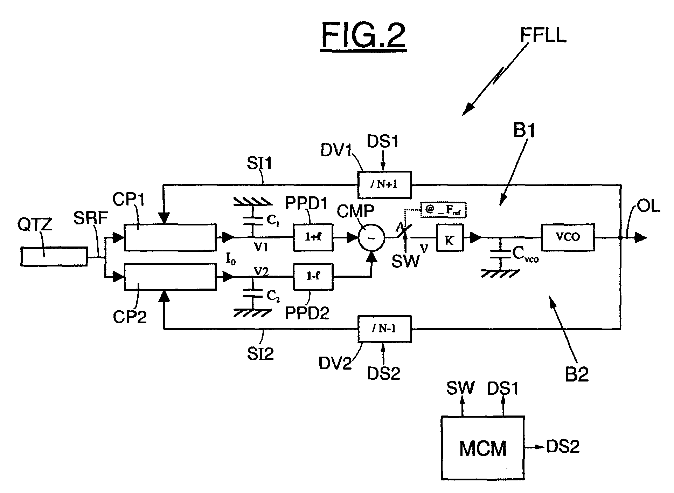

On se réfère maintenant plus particulièrement à la figure 2 pour illustrer un mode de réalisation d'un dispositif synthétiseur de fréquence FFLL selon l'invention.

Ce dispositif comporte un oscillateur commandé en tension VCO dont la sortie délivre le signal de sortie désiré, en l'espèce le signal d'oscillateur local OL (figure 1). Bien entendu, le déphasage entre les deux signaux d'oscillateur local OL illustré sur la figure 1 peut être aisément obtenu en disposant un déphaseur à la sortie de l'oscillateur VCO. Bien que l'on ait représenté ici un oscillateur commandé en tension, tout type d'oscillateur commandé convient, par exemple un oscillateur commandé en courant.

Le dispositif FFLL comporte ici deux boucles B1 et B2.

La première boucle B1 comporte un premier diviseur DV1 capable d'effecteur une division entière, en l'espèce par N+1, du signal de sortie délivré par l'oscillateur VCO. Ce premier signal intermédiaire SI1, délivré par le diviseur DV1 est fourni à des premiers moyens de détermination CP1 composés ici d'un détecteur de front suivi d'une pompe de charge. Ces premiers moyens de détermination CP1 reçoivent par ailleurs un signal de référence SRF, ayant une période de référence $T_{ref}$. Ce signal de référence SRF est délivré par un quartz QTZ.

Un premier condensateur C1 est par ailleurs connecté entre la masse et la sortie des moyens CP1.

Par ailleurs, des premiers moyens de pondération PPD1 sont connectés entre l'autre borne de la capacité du condensateur C1 et la première entrée d'un soustracteur CMP (moyens de comparaison).

La sortie du soustracteur est reliée au filtre de boucle K par l'intermédiaire d'un interrupteur A commandé à la fréquence de référence $F_{ref}$ par un signal de commande SW émis par des moyens de commande MCM.

La sortie du filtre de boucle K est reliée à l'oscillateur VCO ainsi qu'à un condensateur $C_{vco}$ permettant de contrôler la tension de commande de l'oscillateur.

La deuxième boucle B2 du dispositif FFLL comporte un deuxième diviseur DV2 apte à effectuer également une division entière du signal de sortie de l'oscillateur VCO. Ce deuxième diviseur effectue en l'espèce une division par N-1 et délivre un deuxième signal intermédiaire SI2 à des deuxièmes moyens de détermination CP2 ayant une structure analogue aux premiers moyens de détermination CP1.

Ces deuxièmes moyens de détermination reçoivent également le signal de référence SRF. Un deuxième condensateur C2 est relié à la sortie des moyens CP2 ainsi qu'à des deuxièmes moyens de pondération PPD2.

La sortie de ces deuxièmes moyens de pondération PPD2 est reliée à l'autre entrée du soustracteur CMP.

Par ailleurs, les deux diviseurs DV1 et DV2 peuvent être activés ou désactivés par respectivement deux signaux logiques DS1, DS2 également délivrés par les moyens de commande MCM.

Le dispositif selon l'invention permet ainsi de réaliser directement une division par un nombre réel ayant une partie décimale de plusieurs bits, en l'espèce par un nombre égal à N+f où N désigne la partie entière du diviseur réel et f la partie décimale. L'invention se distingue donc de l'art antérieur, et notamment des systèmes à boucle à verrouillage fractionnaires qui prévoit d'effecteur alternativement deux divisions entières.

En effet, selon le mode de réalisation de la figure 2; les divisions entières par N+1 et par N-1 se font simultanément, permettant ainsi de connaître exactement l'écart entre la fréquence de sortie et la fréquence désirée. Ainsi, les boucles réagissent à l'écart réel et non à l'écart entre la fréquence de sortie et un nombre entier de fois la référence. L'écart diminue jusqu'à devenir négligeable. La boucle reste stable et les raies parasites inhérentes aux boucles à verrouillage de phase fractionnaires classiques disparaissent.

Plus précisément, le procédé selon l'invention s'étale sur deux phases, à savoir une phase de mesure et une phase de correction.

La phase de mesure s'effectue sur une période de mesure, par exemple une période du signal de référence $S_{ref}$.

On utilise cette période de mesure pour effectuer la mesure de la fréquence de sortie $F_{out}$. Pendant ce temps, l'ensemble des deux boucles B1 et B2 est ouvert au niveau de l'interrupteur A, juste avant le condensateur $C_{VCO}$ maintenant la tension de commande de l'oscillateur, pour éviter que la réaction de la boucle ne vienne perturber la mesure.

La boucle B2 permet de mesurer l'écart temporel entre le deuxième signal intermédiaire SI2 dont la période est égale à $(N-1)T_{out}$, et le signal de référence ayant la période $T_{ref}$.

Au bout de la mesure, la tension aux bornes du condensateur C2 est égale à

$$V_2 = \frac{I_0}{C_2}\left[T_{ref} - (N-1)T_{out}\right] \qquad (I)$$

La boucle B1 fournit l'écart entre le premier signal intermédiaire SI1 ayant une période égale à $(N+1)T_{out}$, et le signal de référence.

Au bout de la mesure, la tension aux bornes du condensateur C1 est égale à :

$$V_1 = \frac{I_o}{C_1}\left[(N+1)T_{out} - T_{ref}\right] \qquad\qquad (II)$$

Lors de la période suivante du signal de référence, on procède alors à la phase de correction. Les diviseurs de fréquence DV1 et DV2 sont désactivés et remis à 0 et l'interrupteur A est fermé. On soustrait alors les tensions des deux condensateurs, pondérées par des poids de (1+f) et (1-f). La tension V obtenue donne l'écart entre la fréquence de sortie et la fréquence désirée.
Cette tension est fournie par la formule (III) ci-dessous

$$V = (1+f)\frac{I_o}{C_1}\left[(N+1)T_{out} - T_{ref}\right] - (1-f)\frac{I_o}{C_2}\left[T_{ref} - (N-1)T_{out}\right] \qquad (III)$$

Dans l'hypothèse où C1=C2=$C_0$, la tension V est alors fournie par la formule ci-dessous qui se réduit alors à la formule (IV).

$$V = \frac{I_o}{C_O}\left[(N+1)T_{out} - T_{ref} + (N-1)T_{out} - T_{ref} + f\left[(N+1)T_{out} - T_{ref} + T_{ref} - (N-1)T_{out}\right]\right]$$

$$V = \frac{2.I_o}{C_O}\left[(N+f)T_{out} - T_{ref}\right] \qquad\qquad (IV)$$

On dispose donc de l'écart entre la période désirée et la période actuelle.
Cette tension est ensuite transformée en courant pour pouvoir l'intégrer dans le condensateur $C_{VCO}$.
Avant de recommencer la mesure, c'est-à-dire au cours d'un nombre entier de périodes suivantes du signal de référence (par exemple au cours de la période suivante), les capacités des pompes de charge doivent être vidées. Les compteurs seront activés au prochain front du signal de référence.
Ainsi, le système selon l'invention, capable de réaliser une multiplication de fréquence par un nombre réel ayant une partie décimale, conserve tous les avantages des boucles à verrouillage de phase classique tout en supprimant le bruit inhérent aux boucles à verrouillage de phase fractionnaire.

**Revendications**

1. Procédé de génération d'un signal désiré ayant une fréquence désirée égale au produit d'une fréquence de référence par un nombre réel, **caractérisé par le fait qu'**il comporte cycliquement une succession d'une phase de mesure et d'une phase de correction, **par le fait que** la phase de mesure comporte une première division entière de la fréquence du signal de sortie (OL) d'un oscillateur par un premier diviseur entier (N+1) dans un premier moyen (DV1) de division de fréquence de façon à obtenir un premier signal intermédiaire (SI1), une détermination d'un premier signal de mesure représentatif de l'écart temporel entre ce premier signal intermédiaire et un signal de référence (SRF) ayant ladite fréquence de référence, une comparaison (CMP) entre un premier signal de comparaison tiré du premier signal de mesure et un deuxième signal de comparaison dépendant de la période de référence, de la partie entière (N) et de la partie décimale (f) dudit nombre réel, et dudit premier diviseur entier de façon à obtenir un signal d'erreur représentatif de l'écart temporel entre la période du signal de sortie actuel de l'oscillateur et ladite période désirée, et **par le fait que** la phase de correction comporte une désactivation (SW) du premier moyen de division de fréquence et une correction de la commande de l'oscillateur à partir du signal d'erreur, le signal de sortie de l'oscillateur formant ledit signal désiré.

2. Procédé selon la revendication 1, **caractérisé par le fait que** la phase de mesure s'effectue pendant un nombre entier de périodes du signal de référence (SRF), par exemple une période, tandis que la phase de correction s'effectue pendant un autre nombre entier de périodes suivantes du signal de référence, par exemple la période suivante.

**3.** Procédé selon la revendication 1 ou 2, **caractérisé par le fait que** l'élaboration du deuxième signal de comparaison comporte une deuxième division entière de la fréquence du signal de sortie de l'oscillateur par un deuxième diviseur entier (N-1) dans un deuxième moyen (DV2) de division de fréquence de façon à obtenir un deuxième signal intermédiaire (SI2), une détermination d'un deuxième signal de mesure représentatif de l'écart temporel entre ce deuxième signal intermédiaire et le signal de référence, et une pondération du deuxième signal intermédiaire par un deuxième facteur de pondération (1-f) obtenu à partir du premier diviseur entier, de la partie entière et de la partie décimale dudit nombre réel, **par le fait que** l'élaboration du premier signal de comparaison comporte une pondération du premier signal de mesure par un premier facteur de pondération (1+f) obtenu à partir du deuxième diviseur entier, de la partie entière et de la partie décimale dudit nombre réel, et **par le fait que** la phase de correction comporte également une désactivation du deuxième moyen (DV2) de division de fréquence.

**4.** Procédé selon la revendication 3, **caractérisé par le fait que** le premier diviseur entier est égal à N+1, N désignant la partie entière du nombre réel, et le deuxième diviseur entier est égal à N-1, et **par le fait que** le premier facteur de pondération est égal à 1+f, f désignant la partie décimale du nombre réel, et que le deuxième facteur de pondération est égal à 1-f.

**5.** Dispositif de génération d'un signal désiré ayant une fréquence désirée égale au produit d'une fréquence de référence par un nombre réel, **caractérisé par le fait qu'**il comprend

    - un oscillateur commandé (VCO),
    - un premier moyen de division (DV1) apte à effectuer une première division entière de la fréquence du signal de sortie de l'oscillateur commandé en tension par un premier diviseur entier de façon à obtenir un premier signal intermédiaire,
    - des premiers moyens de détermination (CP1) aptes à déterminer un premier signal de mesure représentatif de l'écart temporel entre ce premier signal intermédiaire et un signal de référence ayant ladite fréquence de référence,
    - des premiers moyens d'élaboration (PPD1) aptes à élaborer un premier signal de comparaison tiré du premier signal de mesure,
    - des deuxièmes moyens d'élaboration (B2) aptes à élaborer un deuxième signal de comparaison dépendant de la période de référence, de la partie entière et de la partie décimale dudit nombre réel, et dudit premier diviseur entier, et
    - des moyens de comparaison (CMP) aptes à effectuer une comparaison entre les deux signaux de comparaison de façon à obtenir un signal d'erreur représentatif de l'écart temporel entre la période du signal dé sortie actuel de l'oscillateur et ladite période désirée,
    - un interrupteur (A) connecté entre la sortie des moyens de comparaison et l'entrée de commande de l'oscillateur, et
    - des moyens de commande (MCM) aptes à ouvrir et à fermer successivement et cycliquement l'interrupteur et à désactiver le premier moyen de division lorsque l'interrupteur est fermé, de façon à permettre successivement la détermination du signal d'erreur et la délivrance de ce signal d'erreur sur l'entrée de commande de l'oscillateur, le signal de sortie de l'oscillateur formant ledit signal désiré.

**6.** Dispositif selon la revendication 5, **caractérisé par le fait que** les moyens de commande (MCM) ferment et ouvrent l'interrupteur respectivement pendant des périodes successives du signal de référence.

**7.** Dispositif selon la revendication 5 ou 6, **caractérisé par le fait que** les deuxièmes moyens d'élaboration comportent

    - un deuxième moyen de division (DV2) apte à effectuer une deuxième division entière de la fréquence du signal de sortie de l'oscillateur par un deuxième diviseur entier,
    - des deuxièmes moyens de détermination (CP2) aptes à déterminer un deuxième signal de mesure représentatif de l'écart temporel entre ce deuxième signal intermédiaire et le signal de référence, et
    - des deuxièmes moyens de pondération (PPD2) aptes à effectuer une pondération du deuxième signal intermédiaire par un deuxième facteur de pondération obtenu à partir du premier diviseur entier, de la partie entière et de la partie décimale dudit nombre réel,
    - **par le fait que** les premiers moyens d'élaboration comportent des premiers moyens de pondération (PPD1) aptes à effectuer une pondération du premier signal de mesure par un premier facteur de pondération obtenu à partir du deuxième diviseur entier, de la partie entière et de la partie décimale dudit nombre réel, et
    - **par le fait que** les moyens de commande (MCM) sont également aptes à désactiver le deuxième moyen de division lorsque l'interrupteur est fermé.

8. Dispositif selon la revendication 7, **caractérisé par le fait que** le premier diviseur entier est égal à N+1, N désignant la partie entière du nombre réel, et le deuxième diviseur entier est égal à N-1, et **par le fait que** le premier facteur de pondération est égal à 1+f, f désignant la partie décimale du nombre réel, et que le deuxième facteur de pondération est égal à 1-f.

9. Dispositif selon l'une des revendications 5 à 8, **caractérisé par le fait qu'**il est réalisé sous la forme d'un circuit intégré.

10. Terminal d'un système de communication sans fil, **caractérisé par le fait qu'**il comprend un dispositif selon l'une des revendications 5 à 9.

11. Terminal selon la revendication 10, **caractérisé par le fait qu'**il forme un téléphone mobile cellulaire.

**Patentansprüche**

1. Verfahren zur Erzeugung eines gewünschten Signals, das eine gewünschte Frequenz aufweist, die gleich dem Produkt einer Referenzfrequenz mit einer reellen Zahl ist, **dadurch gekennzeichnet, daß** das Verfahren eine zyklische Abfolge von Meßphase und Korrekturphase aufweist,
   **dadurch**, daß die Meßphase aufweist:

   eine erste ganzzahlige Division der Frequenz des Ausgangssignals (OL) eines Oszillators durch einen ersten ganzzahligen Divisor (N+1) in einer ersten Frequenzdivisionseinrichtung (DV1), um ein erstes Zwischensignal (SI1) zu gewinnen,
   eine Ermittlung eines ersten Meßsignals, das den Zeitabstand zwischen diesem ersten Zwischensignal und einem die Referenzfrequenz aufweisenden Referenzsignal (SRF) repräsentiert,
   einen Vergleich (CMP) zwischen einem aus dem ersten Meßsignal extrahierten ersten Vergleichssignal und einem zweiten Vergleichssignal, das von der Referenzperiode, dem ganzzahligen Anteil (N) und dem dezimalen Anteil (f) der reellen Zahl und dem ersten ganzzahligen Divisor abhängt, um ein Fehlersignal zu gewinnen, das den Zeitabstand zwischen der Periode des aktuellen Ausgangssignals des Oszillators und der gewünschten Periode repräsentiert, und
   **dadurch**, daß die Korrekturphase aufweist:

   eine Deaktivierung (SW) der ersten Frequenzdivisionseinrichtung und eine Korrektur der Steuerung des Oszillators ausgehend von dem Fehlersignal, wobei das Ausgangssignal des Oszillators das gewünschte Signal bildet.

2. Verfahren nach Anspruch 1, **dadurch gekennzeichnet, daß** die Meßphase während einer ganzen Anzahl von Perioden des Referenzsignals (SRF), zum Beispiel einer Periode, durchgeführt wird, wohingegen die Korrekturphase während einer anderen ganzen Anzahl von darauffolgenden Perioden des Referenzsignals, zum Beispiel der nächsten Periode, durchgeführt wird.

3. Verfahren nach Anspruch 1 oder 2, **dadurch gekennzeichnet, daß** die Ausarbeitung des zweiten Vergleichssignals aufweist:

   eine zweite ganzzahlige Division der Frequenz des Ausgangssignals des Oszillators durch einen zweiten ganzzahligen Divisor (N-1) in einer zweiten Frequenzdivisionseinrichtung (DV2), um ein zweites Zwischensignal (SI2) zu gewinnen,
   eine Ermittlung eines zweiten Meßsignals, das den Zeitabstand zwischen diesem zweiten Zwischensignal und dem Referenzsignal repräsentiert, und
   eine Wichtung des zweiten Zwischensignals mit einem zweiten Wichtungsfaktor (1-f), der aus dem ersten ganzzahligen Divisor, dem ganzzahligen Anteil und dem dezimalen Anteil der reellen Zahl gewonnen wird,

   **dadurch**, daß die Ausarbeitung des ersten Vergleichssignals eine Wichtung des ersten Meßsignals mit einem ersten Wichtungsfaktor (1+f) aufweist, der aus dem zweiten ganzzahligen Divisor, dem ganzzahligen Anteil und dem dezimalen Anteil der reellen Zahl gewonnen wird, und
   **dadurch**, daß die Korrekturphase ferner eine Deaktivierung der zweiten Frequenzdivisionseinrichtung (DV2) aufweist.

4. Verfahren nach Anspruch 3, **dadurch gekennzeichnet, daß** der erste ganzzahlige Divisor gleich N+1 ist, wobei N den ganzzahligen Anteil der reellen Zahl bezeichnet, und der zweite ganzzahlige Divisor gleich N-1 ist, und **dadurch**, daß der erste Wichtungsfaktor gleich 1+f ist, wobei f den dezimalen Anteil der reellen Zahl bezeichnet, und daß der zweite Wichtungsfaktor gleich 1-f ist.

5. Vorrichtung zur Erzeugung eines gewünschten Signals, das eine gewünschte Frequenz aufweist, die gleich dem Produkt einer Referenzfrequenz mit einer reellen Zahl ist, **dadurch gekennzeichnet, daß** die Vorrichtung aufweist:

   - einen gesteuerten Oszillator (VCO),
   - eine erste Divisionseinrichtung (DV1), die in der Lage ist, eine erste ganzzahlige Division der Frequenz des Ausgangssignals des spannungsgesteuerten Oszillators durch einen ersten ganzzahligen Divisor durchzuführen, um ein erstes Zwischensignal zu gewinnen,
   - erste Ermittlungseinrichtungen (CP1), die in der Lage sind, ein erstes Meßsignal zu ermitteln, das den Zeitabstand zwischen diesem ersten Zwischensignal und einem Referenzsignal, das die Referenzfrequenz aufweist, zu ermitteln,
   - erste Ausarbeitungseinrichtungen (PPD1), die in der Lage sind, ein aus dem ersten Meßsignal extrahiertes erstes Vergleichssignal auszuarbeiten,
   - zweite Ausarbeitungseinrichtungen (B2), die in der Lage sind, ein zweites Vergleichssignal auszuarbeiten, das von der Referenzperiode, dem ganzzahligen Anteil und dem dezimalen Anteil der reellen Zahl und dem ersten ganzzahligen Divisor abhängt, und
   - Vergleichseinrichtungen (CMP), die in der Lage sind, einen Vergleich zwischen den zwei Vergleichssignalen durchzuführen, um ein erstes Fehlersignal zu gewinnen, das den Zeitabstand zwischen der Periode des aktuellen Ausgangssignals des Oszillators und der gewünschten Periode repräsentiert,
   - einen Schalter (A), der zwischen dem Ausgang der Vergleichseinrichtungen und dem Steuereingang des Oszillators angeordnet ist, und
   - Steuereinrichtungen (MCM), die in der Lage sind, in zyklischer Abfolge den Schalter zu öffnen und zu schließen und die erste Divisionseinrichtung zu deaktivieren, wenn der Schalter geschlossen ist, um aufeinanderfolgend die Ermittlung des Fehlersignals und die Bereitstellung dieses Fehlersignals am Steuereingang des Oszillators zu erlauben, wobei das Ausgangssignal des Oszillators das gewünschte Signal bildet.

6. Vorrichtung nach Anspruch 5, **dadurch gekennzeichnet, daß** die Steuereinrichtungen (MCM) den Schalter jeweils während aufeinanderfolgender Perioden des Referenzsignals schließen und öffnen.

7. Vorrichtung nach Anspruch 5 oder 6, **dadurch gekennzeichnet, daß** die zweiten Ausarbeitungseinrichtungen aufweisen:

   - eine zweite Divisionseinrichtung (DV2), die in der Lage ist, eine zweite ganzzahlige Division der Frequenz des Ausgangssignals des Oszillators durch einen zweiten ganzzahligen Divisor durchzuführen,
   - zweite Ermittlungseinrichtungen (CP2), die in der Lage sind, ein zweites Meßsignal zu ermitteln, das den Zeitabstand zwischen diesem zweiten Zwischensignal und dem Referenzsignal repräsentiert, und
   - zweite Wichtungseinrichtungen (PPD2), die in der Lage sind, eine Wichtung des zweiten Zwischensignals mit einem zweiten Wichtungsfaktor durchzuführen, der aus dem ersten ganzzahligen Divisor, dem ganzzahligen Anteil und dem dezimalen Anteil der reellen Zahl gewonnen wird,
   - **dadurch**, daß die ersten Ausarbeitungseinrichtungen erste Wichtungseinrichtungen (PPD1) aufweisen, die in der Lage sind, eine Wichtung des ersten Meßsignals mit einem ersten Wichtungsfaktor durchzuführen, der aus dem zweiten ganzzahligen Divisor, dem ganzzahligen Anteil und dem dezimalen Anteil der reellen Zahl gewonnen wird, und
   - **dadurch**, daß die Steuereinrichtungen (MCM) ferner in der Lage sind, die zweite Divisionseinrichtung zu deaktivieren, wenn der Schalter geschlossen ist.

8. Vorrichtung nach Anspruch 7, **dadurch gekennzeichnet, daß** der erste ganzzahlige Divisor gleich N+1 ist, wobei N den ganzzahligen Anteil der reellen Zahl bezeichnet, und der zweite ganzzahlige Divisor gleich N-1 ist, und **dadurch**, daß der erste Wichtungsfaktor gleich 1+f ist, wobei f den dezimalen Anteil der reellen Zahl bezeichnet, und daß der zweite Wichtungsfaktor gleich 1-f ist.

9. Vorrichtung nach einem der Ansprüche 5 bis 8, **dadurch gekennzeichnet, daß** sie in Form einer integrierten Schaltung realisiert ist.

**10.** Endgerät eines drahtlosen Kommunikationssystems, **dadurch gekennzeichnet, daß** es eine Vorrichtung nach einem der Ansprüche 5 bis 9 aufweist.

**11.** Endgerät nach Anspruch 10, **dadurch gekennzeichnet, daß** es ein zelluläres Mobiltelefon bildet.

**Claims**

**1.** Method for generating a desired signal having a desired frequency equal to the product of a reference frequency and a real number, **characterized in that** it comprises a measurement phase and a correction phase in periodic succession, **in that** the measurement phase comprises a first integer division of the frequency of the output signal (OL) of an oscillator by a first integer divider (N+1), within a first frequency division means (DV1), so as to obtain a first intermediate signal (SI1), a determination of a first measurement signal representative of the temporal separation between this first intermediate signal and a reference signal (SRF) having the said reference frequency, a comparison (CMP) between a first comparison signal extracted from the first measurement signal and a second comparison signal that depends on the reference period, on the integer part (N) and on the decimal part (f) of the said real number, and on the said integer divider, so as to obtain an error signal representative of the temporal separation between the period of the current output signal of the oscillator and the said desired period, and **in that** the correction phase comprises a deactivation (SW) of the first frequency division means and a correction of the oscillator control based on the error signal, the output signal of the oscillator forming the said desired signal.

**2.** Method according to Claim 1, **characterized in that** the measurement phase is carried out over an integer number of periods of the reference signal (SRF), for example one period, whereas the correction phase is carried out over another integer number of following periods of the reference signal, for example the next period.

**3.** Method according to Claim 1 or 2, **characterized in that** the generation of the second comparison signal comprises a second integer division of the frequency of the oscillator output signal by a second integer divider (N-1), within a second frequency division means (DV2), so as to obtain a second intermediate signal (SI2), a determination of a second measurement signal representative of the temporal separation between this second intermediate signal and the reference signal, and a weighting of the second intermediate signal by a second weighting factor (1-f) obtained from the first integer divider, from the integer part and from the decimal part of the said real number, **in that** the generation of the first comparison signal comprises a weighting of the first measurement signal by a first weighting factor (1+f) obtained from the second integer divider, from the integer part and from the decimal part of the said real number, and **in that** the correction phase also comprises a deactivation of the second frequency division means (DV2).

**4.** Method according to Claim 3, **characterized in that** the first integer divider is equal to N+1, N denoting the integer part of the real number, and the second integer divider is equal to N-1, and **in that** the first weighting factor is equal to 1+f, f denoting the decimal part of the real number, and that the second weighting factor is equal to 1-f.

**5.** Device for generating a desired signal having a desired frequency equal to the product of a reference frequency and a real number, **characterized in that** it comprises:

- a controlled oscillator (VCO),
- a first division means (DV1) capable of performing a first integer division of the frequency of the output signal of the voltage-controlled oscillator by a first integer divider so as to obtain a first intermediate signal,
- first determination means (CP1) capable of determining a first measurement signal representative of the temporal separation between this first intermediate signal and a reference signal having the said reference frequency,
- first generation means (PPD1) capable of generating a first comparison signal extracted from the first measurement signal,
- second generation means (B2) capable of generating a second comparison signal that depends on the reference period, on the integer part and on the decimal part of the said real number, and on the first integer divider, and
- comparison means (CMP) capable of performing a comparison between the two comparison signals so as to obtain an error signal representative of the temporal separation between the period of the current output signal of the oscillator and the said desired period,
- a switch (A) connected between the output of the comparison means and the control input of the oscillator, and
- control means (MCM) capable of successively and periodically opening and closing the switch and of deactivating the first division means when the switch is closed, so as to successively allow the determination of the error signal and the delivery of this error signal onto the control input of the oscillator, the oscillator output signal forming the said desired signal.

**6.** Device according to Claim 5, **characterized in that** the control means (MCM) open and close the switch during respective successive periods of the reference signal.

**7.** Device according to Claim 5 or 6, **characterized in that** the second generation means comprise:

- a second division means (DV2) capable of performing a second integer division of the frequency of the oscillator output signal by a second integer divider,
- second determination means (CP2) capable of determining a second measurement signal representative of the temporal separation between this second intermediate signal and the reference signal, and
- second weighting means (PPD2) capable of performing a weighting of the second intermediate signal by a second weighting factor obtained from the first integer divider, from the integer part and from the decimal part of the said real number,
- **in that** the first generation means comprise first weighting means (PPD1) capable of performing a weighting of the first measurement signal by a first weighting factor obtained from the second integer divider, from the integer part and from the decimal part of the said real number, and
- **in that** the control means (MCM) are also capable of deactivating the second division means when the switch is closed.

**8.** Device according to Claim 7, **characterized in that** the first integer divider is equal to N+1, N denoting the integer part of the real number, and the second integer divider is equal to N-1, and **in that** the first weighting factor is equal to 1+f, f denoting the decimal part of the real number, and that the second weighting factor is equal to 1-f.

**9.** Device according to one of Claims 5 to 8, **characterized in that** it is fabricated in the form of an integrated circuit.

**10.** Terminal of a wireless communications system, **characterized in that** it comprises a device according to one of Claims 5 to 9.

**11.** Terminal according to Claim 10, **characterized in that** it forms a cellular mobile telephone.

## FIG.1

FIG.2